# FASCICULE DE BREVET EUROPEEN

(11) **EP 0 655 783 B1**
(45) Date de publication et mention de la délivrance du brevet: **09.06.1999**
(21) Numéro de dépôt: 94402529.5
(22) Date de dépôt: 08.11.1994
(51) Int. Cl.: H01L 27/02

(54) **Fusible pour circuit intégré**
Schmelzsicherung für integrierte Schaltung
Fuse for integrated circuit

(30) Priorité: 30.11.1993 FR 9314330
(43) Date de publication de la demande: 31.05.1995
(73) Titulaire: STMicroelectronics S.A., 94250 Gentilly (FR)
(72) Inventeur: Fournel, Richard, Cabinet Ballot - Schmit, F-75116 Paris (FR); Fruhauf, Serge, Cabinet Ballot - Schmit, F-75116 Paris (FR); Taillet, François, Cabinet Ballot - Schmit, F-75116 Paris (FR)
(74) Mandataire: Schmit, Christian Norbert Marie

(56) Documents cités:
- EP-A- 0 562 996
- GB-A- 2 247 779
- US-A- 4 403 399
- PATENT ABSTRACTS OF JAPAN vol. 12, no. 265 (E-637) 23 Juillet 1988 & JP-A-63 048 837 (FUJITSU) 1 Mars 1988
- PATENT ABSTRACTS OF JAPAN vol. 12, no. 265 (E-637) 23 Juillet 1988 & JP-A-63 048 838 (FUJITSU) 1 Mars 1988
- Kuan-Yu Fu et al. "On the failure Mechanisms of Titanium Nitride/Titanium Silicide Barrier Contacts under High Current Stress" IEEE Transactions on Electron Devices, Dec. 1988, No. 12
- S.M.Sze "Semiconductor Devices", Physics and Technology, John Wiley &Sons, New York, 1985, pages 372-375

## Description

L'invention concerne les circuits intégrés, et elle concerne plus précisément la réalisation d'éléments de verrouillage irréversibles permettant de modifier de manière définitive les fonctions ou accès à certaines parties du circuit.

On utilisera ci-après l'expression courante "fusible" pour désigner ces éléments de verrouillage, tout en sachant qu'il s'agit d'une expression fonctionnelle imagée et que la structure de ces éléments ne met pas forcément en oeuvre une fusion de matière.

Une application courante de fusibles dans les circuits intégrés est celle des cartes à puces : il est fréquent qu'on veuille interdire l'accès à des zones de mémoire ou à certaines fonctions au fur et à mesure de la fabrication et de la commercialisation de ces cartes.

Un exemple typique est le suivant : la carte fabriquée par un fabricant de carte doit avoir initialement tous ses accès autorisés et toutes ses fonctionnalités autorisées, ne serait-ce que pour des raisons de test. Puis, certaines données confidentielles sont rendues inaccessibles : par exemple, le fabricant de carte ne veut pas qu'on puisse accéder en lecture aux programmes du système d'exploitation (en mémoire morte dans la puce); un ou plusieurs fusibles sont claqués pour interdire cette lecture qui était auparavant possible. La carte peut alors être livrée par exemple à un prestataire de service (banque, compagnie de téléphone, etc.). Celui-ci va placer dans la carte (en mémoire programmable) d'autres programmes et données confidentielles, et il peut vouloir interdire physiquement l'accès en écriture ou en lecture à ces programmes et données. D'autres fusibles pourront être claqués à cette occasion.

Des fusibles utilisés actuellement dans ce type d'application comprennent par exemple :
- des fusibles en silicium polycristallin : une très fine couche de silicium polycristallin reçoit un courant de claquage, s'échauffe, et se volatilise, ouvrant le circuit dans lequel elle est placée. Ce type de fusible présente des problèmes de fiabilité : mauvaise volatilisation, risque de reconstitution du conducteur au cours du temps;
- cellules de mémoire programmables électriquement, du type EEPROM à claquage d'oxyde : l'état vierge de la cellule est assimilé à un état intact du fusible et l'état programmé est assimilé à un état claqué; ce type de verrou est très fiable si on utilise une tension de programmation externe fournissant une énergie suffisante, mais beaucoup moins fiable si on utilise une tension interne à la puce de circuit intégré; l'utilisation d'une tension externe présente des inconvénients (coût supérieur dû à une borne d'alimentation supplémentaire, gêne pour l'utilisateur qui doit prévoir cette tension). D'autre part, le claquage se produit en appliquant une série d'impulsions de tension, mais si le claquage n'est pas réussi à la première tentative, il peut devenir pratiquement impossible;
- cellules de mémoire EEPROM vierges avec diode zener sur source ou drain, que l'on peut effacer une fois mais plus jamais reprogrammer; une haute tension est nécessaire pour le claquage, avec les inconvénients classiques que cela présente : nécessité d'une tension externe avec plot d'accès spécifique, ou d'une tension interne (moins fiable et nécessitant un circuit élévateur de tension à prévoir sur la puce).
On connait du Patent Abstract of Japan, Vol.12, N° 265, 1 mars 1988, un fusible d'isolant analogue dans son principe à un fusible à silicium polycristallin, dont le claquage est obtenu par laser.

Le document GB-A-2 247 779 concerne lui la protection contre des décharges électrostatiques et notamment la protection de jonction semi-conductrice contre le phénomène de claquage inverse.

Le document EP-A-0 562 996 décrit un fusible utilisant une jonction semi-conductrice sur laquelle on dépose une couche de métal apte à former un siliciure par réaction chimique du métal avec le semi-conducteur, et un front raide d'impulsion de tension.

L'invention a pour but de proposer un type de fusible particulièrement simple et pouvant fonctionner à très basse tension.

Selon l'invention on propose de réaliser un fusible à l'aide d'une jonction semiconductrice NP très peu profonde recouverte de métal capable, lorsqu'il s'échauffe, de diffuser dans le semiconducteur jusqu'à court-circuiter la jonction.

L'état de la jonction peut alors être détecté par un circuit de détection simple.

L'invention propose donc un circuit intégré selon la revendication 1.

La région semiconductrice de type opposé pourrait être le substrat semiconducteur dans lequel est formé le circuit intégré. Mais il est plus simple de prévoir que ce soit un caisson diffusé dans ce substrat et de type de conductivité opposé au substrat.

Le métal de contact peut être tout simplement de l'aluminium. La densité de courant qu'il faut appliquer (pour obtenir un échauffement suffisant et une diffusion suffisante du métal vers la jonction) est alors de l'ordre de 1 milliampère par micromètre carré de surface de contact.

Dans le cas de circuits intégrés de technologie classique MOS avec des transistors formés par implantation de source et drain autoalignée par une grille, la région dopée peu profonde peut être une région formée simultanément avec ces implantations de source et drain. Le dopage peut être par exemple de l'ordre de environ 10¹⁸ à environ 10²⁰ atomes/cm³. En technologie CMOS (MOS complémentaires), incluant des transistors à canal N formés dans le substrat de type P- et des transistors à canal P formés dans des caissons de type N, la région dopée peu profonde sera réalisée par une implantation identique à une source ou un drain de transistor à canal P, dans un caisson de type N.

Pour détecter l'état du fusible, on utilise un circuit de détection. Ce circuit de détection peut comporter des moyens pour polariser en direct la jonction entre la région diffusée et la région de type opposé. Les moyens de polarisation peuvent être une polarisation en tension (consistant en l'application d'une faible tension, par exemple quelques dixièmes de volts) ou des moyens de polarisation en courant (consistant en l'application d'un faible courant, par exemple quelques microampères).

Si on utilise une polarisation en courant, la détection peut consister à examiner la tension engendrée aux bornes du fusible; on peut alors prévoir un comparateur à seuil capable de détecter si la tension présente entre le contact métallique et la région semiconductrice de type opposé (substrat ou caisson) est plutôt une tension de jonction NP polarisée en direct (jonction intacte) ou plutôt une chute de tension aux bornes d'une résistance de faible valeur (jonction court-circuitée par le métal).

Dans la pratique, le seuil du comparateur sera compris entre environ 0,2 à 0,3 volt et environ 0,5 à 0,6 volt. Une bonne valeur est 0,3 volt. La valeur de seuil peut être produite par une diode polarisée en direct et non claquée.

Si on utilise au contraire une polarisation qui est plutôt en tension, on peut détecter le courant circulant dans le fusible et le comparer à une valeur de seuil. par exemple, on peut prévoir un miroir de courant pour détecter le courant du fusible et le reporter dans une résistance de manière à créer aux bornes de cette résistance une chute de tension représentative du courant qui parcourt le fusible et donc représentative de l'état du fusible. Un choix approprié du rapport de conversion du miroir de courant et de la valeur de la résistance permet d'établir aux bornes de la résistance une valeur de tension qui représente d'une manière binaire l'état claqué ou non claqué du fusible.

On comprendra qu'une particularité du fusible selon l'invention est qu'il doit être claqué par application d'un courant en polarisation directe de la jonction; mais alors, pour des raisons pratiques, on peut être aussi amené à lire son état en le polarisant en direct, ce qui est particulièrement inattendu; cette lecture en polarisation directe est la raison de la présence :
- soit d'un comparateur à très faible seuil capable de distinguer entre un fusible intact (chute de tension de 0,6 à 0,7 volts d'une jonction polarisée en direct) et un fusible claqué (chute de tension de 0,1 à 0,2 volt d'une jonction court-circuitée par diffusion d'aluminium),
- soit d'un autre système de détection fine capable de repérer une différence entre le courant parcourant une jonction polarisée en direct et le courant parcourant une jonction court-circuitée.

Cependant, il est possible aussi de lire l'état du fusible en polarisant en inverse la jonction entre la région dopée peu profonde et le caisson dans lequel elle est formée. La circuiterie de lecture et claquage est plus complexe mais la différence entre l'état claqué du fusible (jonction court-circuitée) et l'état non claqué (jonction en inverse) est plus facile à détecter.

D'autres caractéristiques et avantages de l'invention apparaîtront à la lecture de la description détaillée qui suit et qui est faite en référence aux dessins annexés dans lesquels :
- la figure 1 représente une coupe transversale du fusible selon l'invention;
- la figure 2 représente un schéma simple de circuit de commande de claquage du fusible et de lecture de l'état du fusible;
- la figure 3 représente un autre schéma de circuit de claquage et de détection.
- la figure 4 représente une variante de schéma, avec lecture en polarisation inverse de la jonction.

Le fusible selon l'invention comporte donc essentiellement une jonction semiconductrice PN peu profonde recouverte de métal pouvant diffuser dans la jonction en cas d'élévation de la température, jusqu'à court-circuiter la jonction.

La jonction est polarisée en direct aussi bien pendant le claquage du fusible que pour la lecture de l'état du fusible.

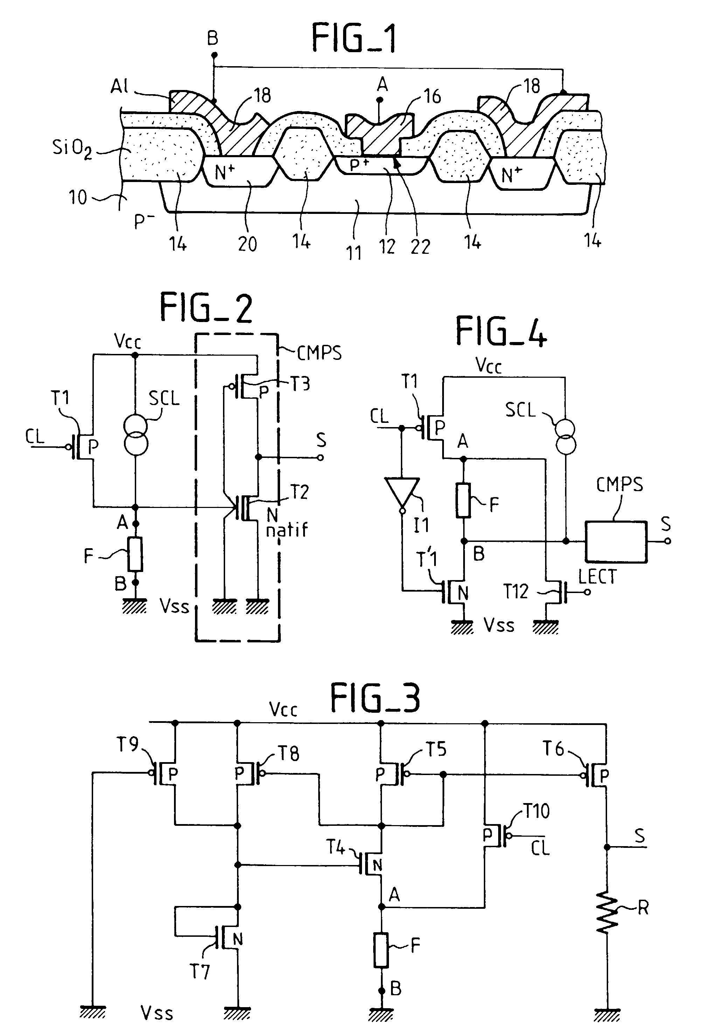

Dans l'exemple de réalisation de la figure 1, la jonction est formée par une région semiconductrice 12 de type P+ implantée dans un caisson 11 de type N, lui-même formé dans un substrat semiconducteur 10 de type P-. Les types de conductivité pourraient d'ailleurs être tous inversés.

Le semiconducteur est en principe du silicium.

La région 12 de type P+ peut être délimitée latéralement par des zones isolantes épaisses 14, de préférence de l'oxyde de silicium épais formé par oxydation thermique localisée. L'étendue de la région 12 peut être de quelques micromètres de long sur quelques micromètres de large.

La profondeur de la région 12 est faible : quelques dixièmes de micromètre, de préférence à peu près 0,2 micromètre.

La concentration en impuretés de type N du caisson 11 est de préférence la même que celle qui sert à former les caissons de transistors à canal P du circuit intégré en technologie CMOS. Cette concentration est par exemple de 10¹⁸ à 10¹⁹ atomes par cm3 environ. L'impureté de dopage est en principe du phosphore ou de l'arsenic.

La concentration en impuretés de type P+ de la région dopée peu profonde 12 est de préférence la même que celle qui sert à former les sources et drains autoalignés des transistors MOS à canal P. Cette concentration est par exemple de quelques 10¹⁸ à 10²⁰ atomes par cm3 environ. L'impureté de dopage est en principe du bore.

La partie supérieure de la région 12 est en contact avec un conducteur métallique 16 constituant une première borne A du fusible. Un autre conducteur métallique 18, relié électriquement au caisson N-, constitue l'autre borne B du fusible. Les conducteurs sont de préférence en aluminium qui est un métal couramment utilisé dans le domaine des circuits intégrés au silicium.

L'aluminium possède de bonnes propriétés de diffusion dans le silicium en présence d'une élévation de la température. C'est la raison pour laquelle on peut réaliser en aluminium le conducteur 16. D'autres métaux ayant la même propriété pourraient évidemment être utilisés à la place de l'aluminium.

Le conducteur 18 est en contact avec une région diffusée 20 de type N+, diffusée localement à la surface du caisson et permettant d'établir un contact ohmique entre le caisson N et la borne B. Cette région N+ 20 est séparée de la région P+ 12, par exemple par une portion de région 14 d'oxyde isolant épais. La région N+ 20 peut entourer toute la région 12; la représentation de la figure 1 correspond à ce cas et c'est pourquoi on voit une portion de région N+ 20 de part et d'autre de la région peu profonde 12.

Le conducteur 16 vient en contact avec au moins une partie de la surface de la région 12, par exemple sur une surface d'un micromètre par un micromètre en son centre. Le contact est désigné par 22 sur la figure 1.

Le fusible fonctionne de la manière suivante :
- lorsqu'il est intact, il constitue une simple diode NP entre les bornes A et B; lorsque cette diode est polarisée en direct et une chute de tension de 0,6 à 0,7 volts environ est présente à ses bornes si le courant de lecture appliqué est suffisant (ce courant est réglé par une source de courant). Le courant de lecture appliqué peut être de quelques microampères pour une surface de jonction d'une dizaine de micromètres carrés.
- pour claquer le fusible, on applique à ses bornes, en polarisation directe, une forte densité de courant, pouvant atteindre par exemple environ 1 milliampère par micromètre carré à l'endroit du contact 22 entre le métal de la borne A et la région P+ 12; la résistance ohmique à l'endroit du contact est suffisamment élevée grâce au fait que la région 12 n'est pas trop fortement dopée; l'échauffement par effet Joule provoque une élévation de température importante à l'endroit du contact, entraînant une fusion de l'aluminium et du silicium à l'endroit du contact (l'aluminium et le silicium forment un eutectique à une température bien plus faible que les températures de fusion de l'aluminium ou du silicium). L'aluminium diffuse alors dans le silicium vers la jonction entre la région 12 et le caisson N. Si une quantité suffisante d'aluminium diffuse jusqu'à la jonction NP (dont la profondeur au dessous du contact 22 est suffisamment faible), la jonction NP sera pratiquement court-circuitée; le fusible est alors dans son état claqué. La durée d'application du courant peut être de quelques secondes (par exemple 10 secondes) pour aboutir à ce résultat.
- dans l'état claqué, le fusible ne se comporte plus comme une diode mais comme une simple résistance de faible valeur; le courant de lecture appliqué (quelques microampères) engendre une chute de tension qui ne peut guère dépasser quelques dizaines de millivolts, soit beaucoup moins que la chute de tension aux bornes de la jonction intacte.

Pour être utilisé comme élément de verrouillage de circuit, le fusible est placé dans un circuit qui permet à la fois une commande électrique de claquage et une détection d'état. Un circuit de commande de claquage et un circuit de détection d'état sont donc associés au fusible.

L'utilisation du fusible réalisée avec une lecture en direct présente l'avantage que, dans ce cas, une des bornes de cette diode est connectée en permanence à la masse. Les tentatives de fraude sont alors plus difficiles.

La figure 2 représente un exemple simple illustrant les principes de cette association. Des circuits plus sophistiqués peuvent être prévus.

Le fusible est désigné par la référence F sur la figure 2.

La borne B du fusible est reliée à la masse Vss qui est la tension la plus basse du circuit, à laquelle est couramment relié le substrat d'un circuit intégré lorsqu'il est de type P.

La borne A du fusible est reliée à une borne d'un transistor de claquage T1 dont une autre borne est reliée à une borne d'alimentation positive Vcc du circuit intégré. Cette tension est la tension normale d'alimentation du circuit intégré (quelques volts) et il faut noter que le principe de fusible décrit dans cette invention ne nécessite pas une tension de claquage particulièrement élevée, contrairement aux fusibles constitués par des cellules de mémoire EPROM.

La grille du transistor de claquage T1 peut recevoir une commande de claquage CL. Cette commande est une tension permettant de rendre conducteur le transistor T1 (tension positive par rapport à Vss si T1 est à canal N, tension nulle ou proche de Vss si T1 est à canal P).

Les dimensions du transistor T1 sont choisies pour permettre de laisser passer un courant tel que la densité de courant à l'endroit du contact 22 aboutisse à une élévation de température suffisante pour faire diffuser le métal de contact vers l'intérieur du semiconducteur. Un transistor capable de laisser passer 1 milliampère peut convenir.

Le circuit de commande de claquage ne comporte que ce transistor T1.

Pour la lecture de l'état du fusible, on prévoit un circuit comprenant une source de courant SCL pour diriger un courant de lecture de quelques microampères dans le fusible, de la borne A vers la borne B. La source de courant est donc connectée entre la borne Vcc et la borne A du fusible. On a donc une polarisation en courant du fusible, dans un sens où la jonction NP est polarisée en direct. La borne A est reliée par ailleurs à l'entrée d'un comparateur à seuil CMPS qui possède une sortie S et qui est capable de fournir sur cette sortie un signal indiquant si la tension en A est supérieure ou inférieure à un seuil déterminé.

Selon l'invention, le seuil de ce comparateur est de moins de 0,5 volt (à peu près), de préférence d'environ 0,2 volt à 0,3 volts.

Si la tension en A (mesurée par rapport à la masse Vss) est supérieure à ce seuil, le fusible est considéré comme intact; si elle est inférieure, le fusible est considéré comme claqué.

Dans l'exemple représenté à la figure 2, le comparateur à seuil est constitué tout simplement par un transistor T2 de type N à très faible tension de seuil (Vt égal à 0,2 volt environ). Ce transistor a sa grille reliée à la borne A et il est relié en série avec un transistor de polarisation à canal P T3 rendu conducteur par sa grille mise à la masse Vss. On obtient un transistor T2 à très faible tension de seuil en évitant de doper son canal avec des impuretés de type P comme on le fait pour les autres transistors à canal N du circuit qui ont plutôt une tension de seuil d'environ 1 volt; par conséquent, le transistor T2 est un transistor dit "natif". Le point de jonction entre les drains des transistors T2 et T3 constitue la sortie S du comparateur et permet de fournir un signal représentant l'état du fusible : signal proche de Vss si le fusible est intact, proche de Vcc si le fusible est claqué. Ce signal peut être utilisé comme on le désire, par exemple pour interdire un chemin d'accès à telle ou telle zone du circuit intégré, notamment dans le cas où le circuit est celui d'une carte à puce.

La figure 3 représente un autre exemple de circuit de commande et de lecture de l'état du fusible. Dans ce schéma, le fusible F est alimenté par un générateur de tension (transistor T4 à canal N ayant sa source reliée à la borne A et son drain relié à un transistor T5 à canal P relié par ailleurs à Vcc). La polarisation du fusible est donc plutôt une polarisation en tension. Elle est telle que la jonction NP tende à être polarisée en direct. La tension appliquée est de quelques dixièmes de volts, ce qu'on obtient grâce à une polarisation de la grille de T4 par un transistor T7 et un transistor T8. Le transistor T7, à canal N, est monté en diode entre la grille de T4 et la masse Vss. Le transistor T8 est relié entre Vcc et T7 et fournit un courant d'alimentation à T7. Ce courant est, dans cet exemple, obtenu par un miroir de courant (T5, T8) à partir du courant traversant le fusible, ce qui établit une contre réaction entre le courant traversant le fusible et la polarisation en tension de ce dernier. Cette contre réaction a pour avantage d'augmenter la dynamique de variation du signal de sortie.

Pour la lecture de l'état du fusible, on prévoit un moyen pour convertir en tension le courant qui passe dans le fusible. Pour cela, on prévoit un transistor T6, monté en miroir de courant par rapport à T5; ce miroir de courant permet de recopier dans une résistance R le courant dans le fusible. Le point de jonction entre la résistance R et le transistor T6 constitue la sortie S du circuit. Si le fusible est intact, le courant qui le parcourt est relativement faible et le courant dans la résistance R est également faible. La tension sur la borne S est proche de Vss. Si au contraire le fusible est claqué, le courant est plus important dans le fusible et donc dans la résistance R. La tension sur la sortie S se rapproche de Vcc. On peut ainsi détecter l'état du fusible.

Un transistor T9 (canal P) connecté entre Vcc et la grille de T4 assure le démarrage correct du circuit à la mise sous tension mais ne joue pas de rôle ensuite. Il a une très faible capacité de conduire du courant (grande longueur et faible largeur).

Enfin, un transistor T10, capable de conduire un courant important, joue le rôle du transistor T1 de la figure 1 pour claquer le fusible.

Dans une autre réalisation, représentée à la figure 4, la lecture se fait en polarisant en inverse la jonction NP entre région dopée 12 et caisson 11. L'extrémité A du fusible est alors mise à la masse, l'extrémité B étant déconnectée de la masse. Il faut prévoir pour cela d'une part un transistor T'1 d'isolation entre la borne B et la masse, et d'autre part un transistor T12 pour relier la borne A à la masse.

Le transistor T'1 est rendu conducteur en même temps que T1 pour le claquage du fusible, à partir du signal de claquage CL. Il est non conducteur pour la lecture de l'état du fusible. Ce transistor doit être aussi gros que le transistor T1 puisqu'il est parcouru par le courant de claquage du fusible. Si le transistor T1 est à canal P et le transistor T'1 à canal N, un inverseur I1 reçoit le signal de claquage CL appliqué à T1 et l'inverse pour l'appliquer à la grille de commande de T'1.

Le transistor T12 qui permet de relier la borne A à la masse peut être un petit transistor à canal N. Il doit seulement être parcouru par un faible courant de lecture. Il est mis en conduction pour la lecture, par un signal de lecture LECT présent en dehors des périodes réservées au claquage.

Le circuit de lecture peut être similaire à celui de la figure 2, avec une source d'alimentation en courant du fusible (par la borne B cette fois) et un simple comparateur à seuil CMPS (relié à la borne B) pour détecter le niveau logique présent sur la borne B (et non la borne A). Le seuil du comparateur est beaucoup moins critique que dans le cas de la lecture en polarisation directe de la jonction. Il peut être de 2 volts environ pour une alimentation de 5 volts. mais l'entrée est alors la borne B et non la borne A du fusible.

Le circuit de lecture pourrait aussi être du même genre que celui de la figure 3, avec encore une fois une inversion des bornes A et B et l'adjonction des transistors T'1 et T12 pour réaliser cette inversion de polarisation entre la lecture et le claquage.

## Revendications

1. Circuit intégré comprenant au moins un fusible physique et un circuit de claquage de ce fusible, ce fusible comprenant une jonction semi-conductrice formée d'une première région (12) semi-conductrice dopée, de faible profondeur, diffusée dans une seconde region (11) semi-conductrice de type de conductivité opposé et un contact metallique (16) formé sur ladite première région, et un circuit de claquage dudit fusible comprenant des moyens pour appliquer une basse tension et un courant à l'endroit dudit contact métallique, caractérisé en ce que ledit contact métallique consiste en un métal apte à diffuser sur toute la profondeur de ladite première région, le contact métallique étant formé directement sur ladite première région et en ce qu'en mode de claquage, les moyens de claquage polarisent en direct la jonction et appliquent un courant de densité suffisante pendant quelques secondes entre ledit contact métal et ladite seconde région, pour y faire diffuser le métal.

2. Circuit intégré selon la revendication 1, caractérisé en ce que la profondeur de ladite première région semi-conductrice dopée est d'environ quelques dixièmes de micromètres.

3. Circuit intégré selon la revendication 1 ou 2, caractérisé en ce que la région semi-conductrice de type opposé est un caisson formé dans le substrat semiconducteur du circuit intégré, ce caisson étant de type de conductivité opposé à celui du substrat.

4. Circuit intégré selon l'une des revendications précédentes, caractérisé en ce que le dopage de ladite première région est d'environ 10⁸ à 10²⁰ atomes par cm³.

5. Circuit intégré selon l'une quelconque des revendications précédentes, caractérisé en ce que le circuit de claquage du fusible comprend des moyens aptes à appliquer un courant d'une densité de l'ordre de 1 milliampère par micromètre carré à l'endroit du contact.

6. Circuit intégré selon l'une des revendications précédentes, caractérisé en ce qu'il comprend en outre un circuit de lecture du fusible apte à polariser la jonction en direct et à lui appliquer un courant de lecture de faible valeur.

7. Circuit intégré selon la revendication 6, caractérisé en ce que ledit circuit de lecture comprend un comparateur à seuil d'un seuil d'environ 0,3 volt, dont l'entrée est connecté à ladite première région.

8. Circuit intégré selon l'une quelconque des revendications 1 à 5, caractérisé en ce qu'il comprend en outre un circuit de lecture aux bornes du fusible comprenant des moyens pour appliquer une faible tension de polarisation en direct à la jonction et un convertisseur courant/tension pour convertir en tension le courant parcourant le fusible.

9. Circuit intégré selon la revendication 8, caractérisé en ce que ledit convertisseur comporte un miroir de courant et une résistance.

10. Circuit intégré selon l'une quelconque des revendications 1 à 5, caractérisé en ce qu'il comprend en outre un circuit de lecture du fusible apte à polariser la jonction en inverse et à lui appliquer un courant de lecture de faible valeur.

11. Circuit intégré selon la revendication 10, caractérisé en ce qu'il comprend un comparateur à seuil dont l'entrée est connectée à ladite seconde région de type opposé.

## Patentansprüche

1. Integrierter Schaltkreis mit wenigstens einer physikalischen Sicherung und einem Schaltkreis zum Durchbrennen dieser Sicherung, wobei die Sicherung einen Halbleiterübergang aus einem ersten dotierten Halbleiterbereich (12) niedriger Tiefe, der in einen zweiten Halbleiterbereich vom entgegengesetzten Leitfähigkeitstyp diffundiert ist, und einen metallischen Kontakt (16) auf dem ersten Bereich umfaßt und ein Schaltkreis zum Durchbrennen der Sicherung Mittel umfaßt, um eine niedrige Spannung und Strom an dem Ort des metallischen Kontaktes anzulegen,
**dadurch gekennzeichnet,** daß
der metallische Kontakt aus einem Metall besteht, das zum Diffundieren über die gesamte Tiefe des ersten Bereiches geeignet ist, wobei der metallische Kontakt direkt auf dem ersten Bereich angeordnet ist, und daß in der Phase des Durchbrennens die Mittel zum Durchbrennen den Übergang in Durchlaßrichtung vorspannen und einen Strom mit ausreichender Dichte für einige Sekunden zwischen dem Metallkontakt und dem zweiten Bereich fließen lassen, um dort das Metall diffundieren zu lassen.

2. Integrierter Schaltkreis nach Anspruch 1,
dadurch gekennzeichnet, daß
die Tiefe des dotierten ersten Halbleiterbereiches in etwa einige Zehntel Mikrometer beträgt.

3. Integrierter Schaltkreis nach Anspruch 1 oder 2,
dadurch gekennzeichnet, daß
der Halbleiterbereich vom entgegengesetzten Typ eine Wanne in dem Halbleitersubstrat des integrierten Schaltkreises ist, wobei die Wanne vom Leitfähigkeitstyp ist, der dem des Substrats entgegengesetzt ist.

4. Integrierter Schaltkreis nach einem der vorangehenden Ansprüche,
dadurch gekennzeichnet, daß
die Dotierung des ersten Bereiches in etwa 10¹⁸ bis 10²⁰ Atome pro cm³ beträgt.

5. Integrierter Schaltkreis nach einem der vorangehenden Ansprüche,
dadurch gekennzeichnet, daß
der Schaltkreis zum Durchbrennen der Sicherung Mittel umfaßt, die geeignet sind, einen Strom mit einer Dichte in der Ordnung von 1 Milliampere pro Mikrometer im Quadrat am Ort des Kontaktes fließen zu lassen.

6. Integrierter Schaltkreis nach einem der vorangehenden Ansprüche,
dadurch gekennzeichnet, daß
er außerdem einen Schaltkreis zum Lesen der Sicherung umfaßt, der dazu geeignet ist, den Übergang in Durchlaßrichtung vorzuspannen und durch ihn einen Lesestrom mit kleinem Wert fließen zu lassen.

7. Integrierter Schaltkreis nach Anspruch 6,
dadurch gekennzeichnet, daß
der Leseschaltkreis einen Schwellenkomparator mit einer Schwelle von etwa 0,3 Volt umfaßt, dessen Eingang mit dem ersten Bereich verbunden ist.

8. Integrierter Schaltkreis nach einem der Ansprüche 1 bis 5,
dadurch gekennzeichnet, daß
er außerdem einen Leseschaltkreis an den Anschlüssen der Sicherung umfaßt, der Mittel zum Anlegen einer schwachen Spannung zum Vorspannen in Durchlaßrichtung des Übergangs und einen Strom/Spannungskonverter zum Konvertieren des Stromes durch die Sicherung in Spannung umfaßt.

9. Integrierter Schaltkreis nach Anspruch 8,
dadurch gekennzeichnet, daß
der Konverter einen Stromspiegel und einen Widerstand umfaßt.

10. Integrierter Schaltkreis nach einem der Ansprüche 1 bis 5,
dadurch gekennzeichnet, daß
er außerdem einen Schaltkreis zum Lesen der Sicherung umfaßt, der geeignet ist, den Übergang in Sperrrichtung vorzuspannen und durch ihn einen Lesestrom mit kleinem Wert fließen zu lassen.

11. Integrierter Schaltkreis nach Anspruch 10,
dadurch gekennzeichnet, daß
er einen Schwellenkomparator umfaßt, dessen Eingang mit dem zweiten Bereich vom entgegengesetzten Typ verbunden ist.

## Claims

1. Integrated circuit comprising at least one physical fuse and a breakdown circuit for this fuse, the said fuse comprising a semiconductor junction formed by a first shallow doped semiconductor region (12), diffused in a second semiconductor region (11) of the opposite conductivity type and a metallic contact (16) formed on the said first region, and a breakdown circuit for the said fuse comprising means for applying a low voltage and a current at the position of the said metallic contact, characterised in that the said metallic contact consists of a metal able to diffuse over the entire depth of the said first region, the metallic contact being formed directly on the said first region and in that, in breakdown mode, the breakdown means direct-bias the junction and apply a current of sufficient density for a few seconds between the said metal contact and the said second region, in order to cause the metal to diffuse thereon.

2. Integrated circuit according to Claim 1, characterised in that the depth of the said first doped semiconductor region is approximately a few tenths of a micrometer.

3. Integrated circuit according to Claim 1 or 2, characterised in that the semiconductor region of the opposite type is a well formed in the semiconductor substrate of the integrated circuit, this well being of the opposite conductivity type to that of the substrate.

4. Integrated circuit according to one of the preceding claims, characterised in that the doping of the said first region is approximately 10⁸ to 10²⁰ atoms per cm³.

5. Integrated circuit according to any one of the preceding claims, characterised in that the fuse breakdown circuit comprises means able to apply a current with a density of around one milliampere per square micrometer at the position of the contact.

6. Integrated circuit according to one of the preceding claims, characterised in that it also comprises a fuse reading circuit able to direct-bias the junction and to apply a low-value reading current to it.

7. Integrated circuit according to Claim 6, characterised in that the said reading circuit comprises a threshold comparator with a threshold of approximately 0.3 volts, whose input is connected to the said first region.

8. Integrated circuit according to any one of Claims 1 to 5, characterised in that it also comprises a reading circuit at the terminals of the fuse comprising means for applying a low direct-biasing voltage to the junction and a current-to-voltage converter for converting the current passing through the fuse into a voltage.

9. Integrated circuit according to Claim 8, characterised in that the said converter has a current mirror and a resistor.

10. Integrated circuit according to any one of Claims 1 to 5, characterised in that it also comprises a reading circuit for the fuse able to reverse-bias the junction and to apply a lowvalue reading current to it.

11. Integrated circuit according to Claim 10, characterised in that it comprises a threshold comparator whose input is connected to the said second region of the opposite type.
